Europäisches Patentamt

European Patent Office

Office européen des brevets

(19)

(11) Publication number:

0 324 487
A2

(12) **EUROPEAN PATENT APPLICATION**

(21) Application number: 89100507.6

(22) Date of filing: 13.01.89

(51) Int. Cl.⁴: **H03K 17/18**

(30) Priority: 15.01.88 CS 282/88

(43) Date of publication of application:
19.07.89 Bulletin 89/29

(84) Designated Contracting States:
AT CH DE FR GR IT LI

(71) Applicant: **CKD PRAHA, kombinát**
**U Kolbenky 159**
**Prag 9(CS)**

(72) Inventor: **Kokes, Antonin, RNDr. CSc.**
**Slunná 27**
**Prag 6(CS)**

(74) Representative: **Patentanwälte Beetz sen. -**
**Beetz jun. Timpe - Siegfried -**
**Schmitt-Fumian- Mayr**
**Steinsdorfstrasse 10**
**D-8000 München 22(DE)**

(54) **Circuit arrangement for determination of the end of disconnection time interval of a switch comprising at least one bipolar transistor.**

(57) Circuit arrangement for determination of the disconnection time interval of a switch comprising at least one bipolar transistor (2) controlled by a current source, between the base and the emitter of which transistor (2) the input of a threshold voltage discriminator (3) provided with an output for indication of the disconnection time is connected.

FIG. 1

EP 0 324 487 A2

# Circuit arrangement for determination of the end of disconnection time interval of a switch comprising at least one bipolar transistor

The invention relates to a circuit arrangement for determination of the end of the disconnection time of a switch comprising at least one bipolar transistor.

Actually utilized circuits for the determination of the end of the disconnection time of bipolar transistors which are in a state of saturated condition are mainly designed for laboratory application and apply a measurement of the collector current in the course of the disconnection process. These arrangements are most complicated and expensive, they are in addition unable to determine ends of the disconnection time of a transistor where no current flows. In order to determine the end of the disconnection time of transistors operating in industrial applications, for instance at inverse rectifiers, arrangements are used which are complicated and expensive and in cases where no current flows through the transistor also ineffective.

It is the object of the present invention to provide an arrangement for determination of the end of disconnection time of a switch comprising a bipolar transistor, which is capable to determine this end also in case where no current flows through the transistor.

According to the presesnt invention this object is achieved with a circuit arrangement as claimed in claim 1. Dependent claims are directed on features of preferred embodiments of the invention.

An advantage of the circuit arrangement according to the present invention is both its simplicity and also the feature that it determines the end of the disconnection time of a transistor even if no current flows through the transistor, which is required if similar transistors are applied in inverted rectifiers.

The present invention will become more apparent by the description of preferred embodiments.

An examplary embodiment of a circuit arrangement according to this invention is shown in the attached drawing, where

Fig. 1 shows a bloc wiring diagram of a circuit arrangement, and

Fig. 2 one possible concrete realization thereof.

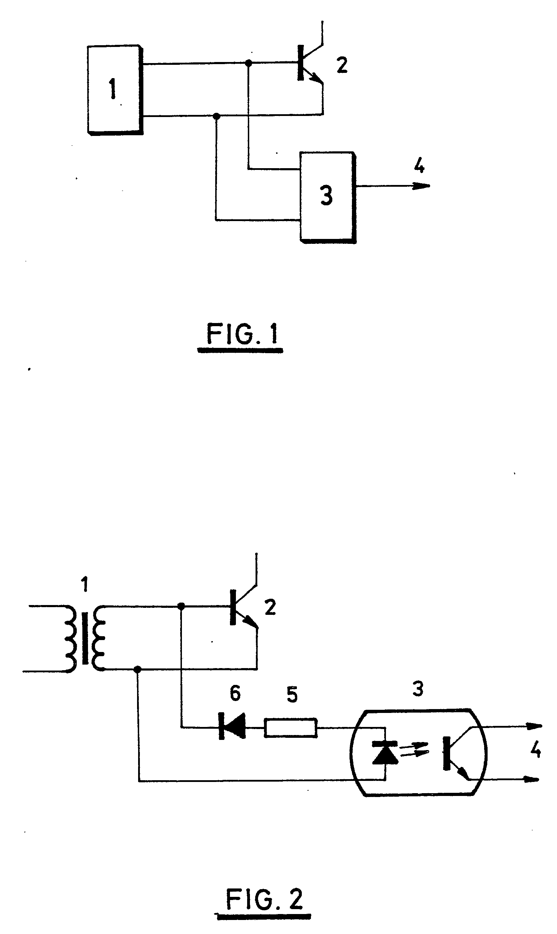

With reference to Fig. 1 the input of a threshold voltage discriminator 3 provided with an output 4 for signalization of the end of the connection time of a transistor 2 is connected between the base and the emitter of transistor 2 controlled by a current source.

In the circuit arrangement shown in Fig. 2 the current source 1 is represented by a transformer and the threshold voltage discriminator 3 is realized by an optoelectric connecting element. The input of the optoelectric connecting element is connected by means of a resistor 5 and a diode 6 between the base and the emitter of the transistor 2.

The threshold voltage discriminator 3 can be also realized by a transformer as a transmission element, the primary winding of which is connected between the base and the emitter of the transistor 2 by means of a resistor 5 or a diode 6. This arrangement is suitable if the ambient temperature is beyond the working temperature of an optoelectric coupling element.

The operation of the circuit arrangement according to this invention is based on the circumstance that the transistor maintains the voltage between the base and the emitter in saturation corresponding to the potential of the conducting zone of the utilized semiconductor. The voltage base-emitter can drop or even possibly change its polarity only after charge carriers from the zone base-emitter have vanished. This phenomen occurs also if no current flows through the collector of transistor 2.

The circuit arrangement according to Fig. 2 operates as follows. The transistor 2 is excited by current from the secondary winding of the transformer, which in this case operates as a current source 1. After disconnection of the current in the primary winding of the transformer, the direction of the current of the base of the transistor is changed due to demagnetization of the transformer core. The voltage of the base maintains, however, its polarity until the end of the disconnection time interval of the transistor 2. Thereafter, as the current of the secondary winding continues, the polarity of the voltage base-emitter of the transistor 2 is changed and through diode 6 and resistor 5 a current starts to flow through the input of the optoelectric coupling element, which forms a threshold voltage discriminator 3, the output 4 of which signalizes by closing the end of the disconnection time of the transistor 2.

If a transformer with a diode 6 or a resistor 5 is utilized as a threshold voltage discriminator 3, the end of the disconnection time interval is indicated by a pulse on the secondary winding of said transformer.

This circuit arrangement reduces the complexity and the large number of components for circuits of power bridge inverted rectifiers with transistor switches.

**Claims**

1. Circuit arrangement for determination of the end of the disconnection time interval of a switch comprising at least one bipolar transistor (2), characterized in that
the input of a threshold voltage discriminator (3) provided with an output (4) for signalization of the end of the disconnection time interval is connected between the base and the emitter of the transistor (2) controlled by a current source (1).

2. Circuit arrangement as in claim 1, characterized in that the threshold voltage discriminator (3) is an optoelectric coupling element.

3. Circuit arrangement as in claim 1, characterized in that the threshold voltage discriminator (3) is a transformer, the primary winding of which forms the input of said threshold voltage discriminator (3).

4. Circuit arrangement as in one of claims 1, 2, 3, characterized in that the input of the threshold voltage discriminator (3) is connected between the base and the emitter of the transistor (2) by way of a resistor (5) or a diode (6).

FIG.1

FIG.2